# EUROPEAN PATENT SPECIFICATION

(11) **EP 2 305 467 B1**
(45) Date of publication and mention of the grant of the patent: **11.01.2017**
(21) Application number: 10012032.8
(22) Date of filing: 08.03.2001
(51) Int. Cl.: B41F 15/34, B41F 15/36

(54) **Improvements relating to screen printing apparatus**
Verbesserungen in bezug auf Siebdruckmaschinen
Perfectionnements en relation avec des machines d'impression par sérigraphie

(30) Priority: 08.03.2000 GB 0005582
(43) Date of publication of application: 06.04.2011
(62) Divisional of application: 01914004.5
(73) Proprietor: ASM Assembly Systems Switzerland GmbH, 8005 Zürich (CH)
(72) Inventor: McEvoy, Ian Patrick, Weymouth Dorset DT4 9TH (GB); Knowles, John Bruce, Weymouth Dorset DT4 9TH (GB)
(74) Representative: Boden, Keith McMurray

(56) References cited:
- WO-A-99/14049
- DE-A1- 4 239 995
- US-A- 4 063 501
- US-A- 5 436 028

## Description

The present invention relates to a screen printing apparatus for and method of screen printing predeterminable patterns of material deposits onto workpieces, in particular, though not exclusively, electronic components such as circuit boards and the like.

Such circuit boards typically comprise a printed circuit board (PCB) or substrate on which various electronic components are mounted and connected to conductive tracks by an electrically-conductive material provided thereon in a predetermined pattern. In a first manufacturing step, an electrically-conductive material is printed on the printed circuit board or substrate through a printing screen. In a further manufacturing step, electronic components are then mounted to the printed circuit board or substrate such that those components are connected to the conductive tracks to form an electric circuit.

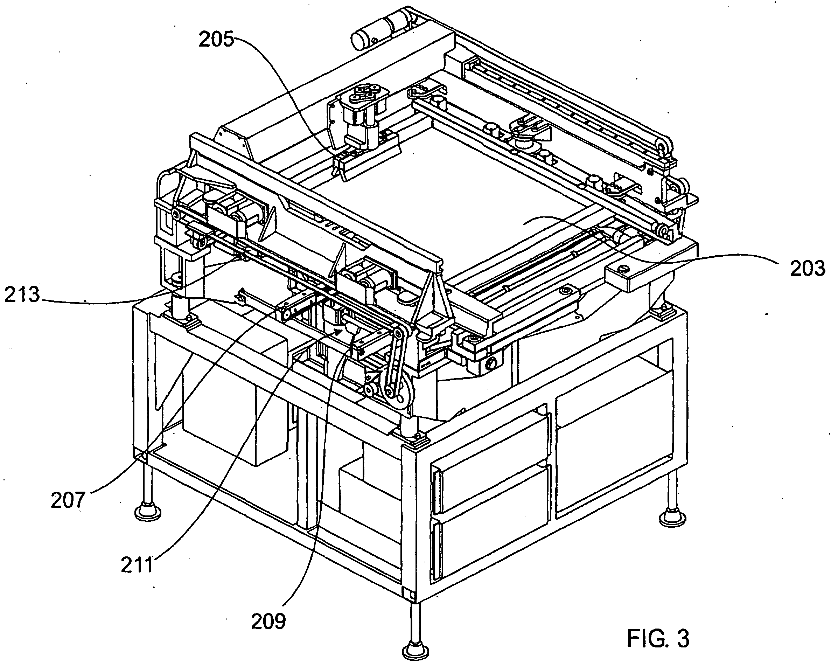

Figure 3 illustrates a known screen printing apparatus. The apparatus comprises a substantially immobile printing screen 203 and a print head 205 which is movable back and forth across the printing screen 203 along a Y axis to drive printing material through a pattern in the printing screen 203 and onto a workpiece disposed therebelow. The apparatus further comprises a workpiece transport device which includes a pair of transport rails 207, 209 along which workpieces are transported to the printing zone, and a workpiece support mechanism 211 disposed beneath the printing screen 203.

The apparatus further comprises a video camera 213 which is movable along X and Y axes to position the camera 213 at known positions between the workpiece and the printing screen 203 to measure any misalignment of the workpiece and the printing screen 203. Once any misalignment of the workpiece and the printing screen 203 has been measured, positioning actuators are operated as required to correctly align the workpiece with the printing screen 203 before printing commences. In this apparatus. X axis, Y axis and θ axis positioning actuators are provided to translate or rotate the printing screen 203. as required, and correctly align the printing screen 203 with the workpiece disposed therebelow. Typically, any movement of the printing screen 203 is limited to less than 10 mm or 1.5 degrees, and is purely for aligning the printing screen 203 with a workpiece to be printed.

Whilst the above-mentioned prior art screen printing apparatus is highly efficient in the high speed and high throughput production of PCBs, the apparatus lacks flexibility in being dedicated solely to screen printing and cannot easily be combined with other functions.

A further disadvantage is that the prior art screen printing apparatus is of fixed size, each one being limited to printing onto a particular range of workpiece sizes, typically to a range of workpieces that are smaller than the printing screen.

The prior art screen printing apparatus is also limited to printing onto planar workpieces, as the printing screen is only movable to a limited extent in X, Y and θ axes. As electronic devices become smaller, it is envisaged that printing of non-planar workpieces may be required; such printing of non-planar workpieces not being possible with the prior art apparatus.

US-A-4063501 discloses a removable module carrying a screen for a screen printing machine.

It is therefore an aim of the present invention to address, and preferably alleviate, the impact of at least some of the above-described disadvantages associated with the prior art screen printing apparatus.

Accordingly, the present invention provides a method of printing a predeterminable pattern of deposits of printing material onto a workpiece, the method comprising the steps of: selecting a first print module; positioning the first-selected print module in a predeterminable position above the workpiece in a printing zone; printing deposits of printing material onto a workpiece using the first-selected print module; returning the first-selected print module; selecting a second print module; positioning the second-selected print module in a predeterminable position above the workpiece in the printing zone; and printing deposits of printing material onto the workpiece using the second-selected print module.

The present invention also provides a screen printing apparatus for printing a predeterminable pattern of deposits of printing material onto a workpiece, the screen printing apparatus comprising: a plurality of print modules, each comprising, as a unitary assembly, a printing screen, a print head movable across the printing screen, and a drive mechanism for moving the print head with respect to the printing screen; and a positioning unit for positioning, in succession, a first-selected print module in a predeterminable position above the workpiece in a printing zone and a second-selected print module in a predeterminable position above the workpiece in the printing zone.

The present invention also extends to a screen printing apparatus comprising a plurality of the above-described print modules, each having a different function, and movement means for selecting and moving the print modules. In a preferred embodiment the apparatus further comprises a controller for selecting and interchanging the print modules from the printing zone.

The present invention also relates to the use of a printing screen in a screen printing apparatus for printing a predeterminable pattern of deposits of printing material onto a workpiece, wherein the printing screen has a smaller lateral dimension than that of the workpiece.

The present invention further relates to the use of a print module, comprising, as a unitary assembly, a printing screen and a print head movable across the printing screen, for printing a predeterminable pattern of deposits of printing material onto a workpiece.

It is an advantage of the present invention that the printing screen can be easily cleaned by lifting the print module from the workpiece and wiping the same on a cleaning station to remove any excess printing material and other debris from the printing screen. Once clean, the print module can be returned for further printing operations.

In one embodiment the screen printing apparatus is provided as part of a kit which comprises a plurality of detachable and interchangeable units, such as, for example, a screen printing unit and a component placement unit, means for selecting one or more of the units and respective moving means for moving the one or more selected units with respect to a workpiece.

Preferred embodiments of the present invention will now be described hereinbelow by way of example only with reference to the accompanying drawings, in which:
Figure 1 illustrates a screen printing apparatus in accordance with a first embodiment of the present invention;
Figure 2 illustrates a screen printing apparatus in accordance with a second embodiment of the present invention; and
Figure 3 illustrates a prior art screen printing apparatus.

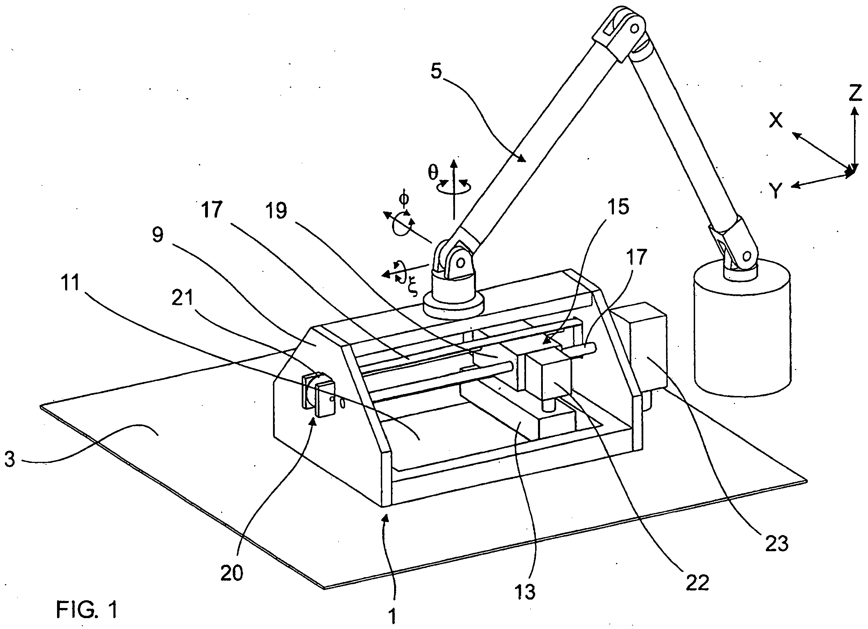

Figure 1 illustrates a screen printing apparatus in accordance with a first embodiment of the present invention.

The apparatus comprises a print module 1 for printing a pattern of deposits of a printing material on a workpiece 3, in this embodiment a circuit board, an articulated, robotic positioning arm 5 for positioning the print module 1 on the workpiece 3, and a controller for controlling the print module 1 and the robotic arm 5.

The apparatus further comprises a workpiece transport device for transporting workpieces 3 to a printing zone in which the print module 1 is operable to print material deposits on a respective workpiece 3. In a preferred embodiment the workpiece transport device includes a pair of guide rails along which workpieces 3 are transported to the printing zone.

The print module 1 is a unitary assembly which comprises a housing 9, a printing screen 11 which is mounted to the housing 9, a print head 13 which is movably disposed relative to the housing 9 to apply printing material to the printing screen 11 and print material deposits on the workpiece 3, and a carriage assembly 15 for supporting and driving the print head 13 over the printing screen 11.

The print head 13 comprises a squeegee print head or a pressure-driven print head as disclosed, for example, in WO-A-98/16387. In a preferred embodiment the print head 13 is a pressure-driven print head; such a print head 13 advantageously allowing for the printing of inverted workpieces 3.

The carriage assembly 15 comprises a pair of guide rails 17, 17 which are mounted to the housing 9, a support block 19 which is slideably disposed to the guide rails 17, 17 and supports the print head 13, and a drive unit 20 which includes a motor-driven continuous drive belt 21 for driving the support block 19 and hence the print head 13 over the printing screen 11. In alternative embodiments the carriage assembly 15 could be driven by a worm drive, a pulley system or any other conventional drive mechanism.

The carriage assembly 15 further comprises at least one actuator 22 for biasing the print head 13 into pressure contact with the printing screen 11 during printing.

The print module 1 further comprises an alignment system 23 for aligning the print module 1 to the workpiece 3 as required. In a preferred embodiment the alignment system 23 includes a video camera for locating fiducials or other locating indicators on the workpiece 3. One suitable system is disclosed in WO-A-95/14575 and US-A-5752446.

In a preferred embodiment the print module 1 is detachable, preferably automatically, from the robotic arm 5 such that different print modules 1, for example, with differently patterned and/or sized printing screens 11, can be interchanged as required. In one embodiment the print module 1 could be interchanged for each print run, potentially comprising a single workpiece 3, to allow for the printing of different patterns and/or differently-sized workpieces 3. In another embodiment the print module 1 could be interchanged to allow for the printing of a plurality of different patterns and/or pattern sizes on a single workpiece 3. It is a particular advantage that the print module 1 can be readily interchanged, allowing for the use of print modules 1 having different screen patterns and/or screen sizes.

In this embodiment the print module 1 has a significantly smaller lateral dimension than the workpiece 3. In this way, the print module 1 can, for example, be operated to print in a recess in the surface of the workpiece 3, which recess would not be accessible when using a printing screen 11 having the same lateral dimension as the workpiece 3, and also print a plurality of different patterns on the same workpiece 3. The present invention thus enables different combinations of circuit patterns to be printed easily and rapidly on a workpiece 3 without the need for dedicated printing screens 11 for each of the particular combinations of circuit patterns. Of course, in other embodiments the print module 1 could have a lateral dimension the same size or greater than the workpiece 3.

The robotic arm 5 is configured to provide for movement of the print module 1 in the X. Y and Z axes, which movement allows for the positioning of the print module 1 on the surface of the workpiece 3. In this embodiment the robotic arm 5 is configured to provide for angular rotation ϕ, ξ, θ of the print module 1 about each of the X. Y and Z axes. By providing for angular rotation θ about the Z axis, that is, an axis perpendicular to the plane of the printing screen 11. a pattern in the printing screen 11 can be deposited with any orient on a planar surface of the workpiece 3. By further providing for angular rotation ϕ, ξ about the X and Y axes, the print module 1 can be translated and rotated to any position in space and allows for printing onto non-planar surfaces.

In this embodiment the robotic arm 5 is attached to the print module 1 by a mechanical connection. In this embodiment the robotic arm 5 includes a clamp and the print module I includes a structural feature, for example, a a protrusion or a handle, which is engaged by the clamp on the robotic arm 5. In another embodiment the print module 1 includes a clamp and the robotic arm 5 includes a structural feature, for example, a protrusion or a handle, which is engaged by the clamp on the print module 1.

In another embodiment the robotic arm 5 can be attached to the print module 1 by a magnetic connection. In one variant the robotic arm 5 could include an electromagnet which is magnetically clamped to the print module 1. In another variant the print module 1 could include an electromagnet which is magnetically clamped to the robotic arm 5.

In this embodiment the controller is a programmable computer. The controller can be programmed to position the print module 1 at the required position or sequentially at the required positions and control the operation of the print module 1.

In one mode of operation, the controller is programmed to operate the workpiece transport device to inwardly transport a workpiece 3 to the printing zone, and then operate the robotic arm 5 first to pick up a selected print module 1 from a store in an acquiring step, position the selected print module 1 in a predetermined position above the workpiece 3, and then, in a printing step, move the selected print module 1 into abutment with the workpiece 3 and drive the print head 13 across the printing screen 11 to deposit a pattern of deposits of printing material onto the workpiece 3. The printing step can then be repeated on further workpieces 3 until a given print run is completed. Where a plurality of workpieces 3 are to be printed in a print run, then at the same time, while a workpiece 3 is being printed, a new workpiece 3 to be printed is transported to the printing zone and a printed workpiece 3 is transported from the printing zone. The print module 1 is then returned to the store by the robotic arm 5 under the control of the controller. In a subsequent print run, a different print module 1. for example, with a differently-patterned printing screen 11. could be picked up by the robotic arm 5, whereupon the above steps would then be repeated to provide a print run of workpieces 3 having the different printed pattern thereon. The printing steps may be interrupted with a cleaning step in which the print module 1 is moved to a cleaning station and the printing screen 11 wiped clean, as required.

In another mode of operation, where a customized pattern of deposits is to be printed using a plurality of print modules 1. the controller is programmed to operate the workpiece transport device to inwardly transport a workpiece 3 to the printing zone, and then operate the robotic arm 5 to in turn select and operate a plurality of different print modules 1 to achieve the required pattern of deposits of printing material, with the operation of each of the print modules 1 being as described hereinabove.

In a preferred embodiment the controller is programmable "on-the-fly" so that new instructions can be inputted, for example, for a print run requiring yet another print module 1, without having to interrupt the current print run.

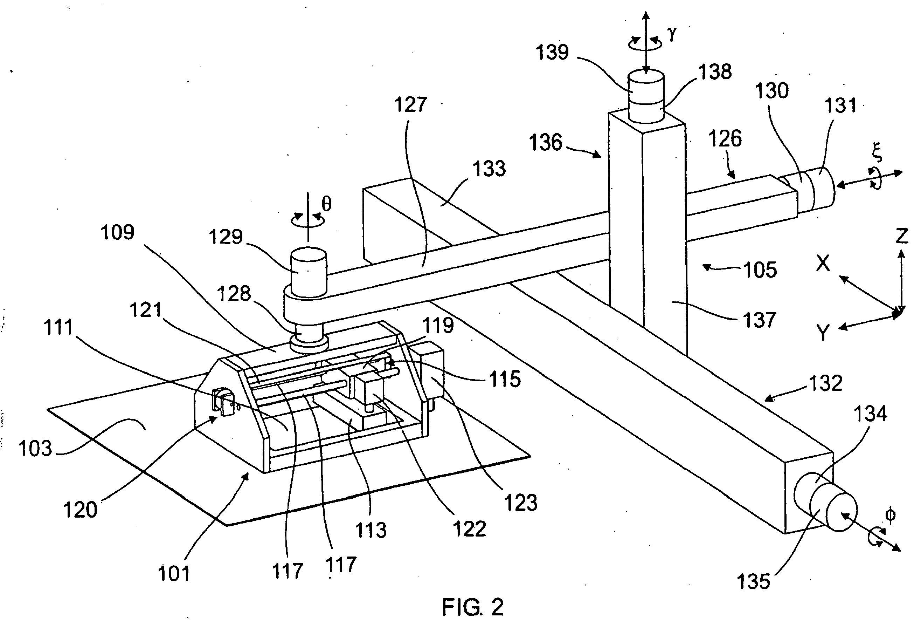

Figure 2 illustrates a screen printing apparatus in accordance with a second embodiment of the present invention. This embodiment utilises a Cartesian positioning system.

The apparatus comprises a print module 101 for printing a pattern of deposits of a printing material on a workpiece 103, a positioning assembly 105 for positioning the print module 101 on the workpiece 103, and a controller for controlling the print module 101 and the positioning assembly 105.

The apparatus further comprises a workpiece transport device for transporting workpieces 103 to a printing zone in which the print module 101 is operable to print material deposits on a respective workpiece 103. In a preferred embodiment the workpiece transport device includes a pair of guide rails along which workpieces 103 are transported to the printing zone.

The print module 101 is a unitary assembly which comprises a housing 109, a printing screen 111 which is mounted to the housing 109, a print head 113 which is movably disposed relative to the housing 109 to apply printing material to the printing screen 111 and print material deposits on the workpiece 103, and a carriage assembly 115 for supporting and driving the print head 13 over the printing screen 111.

The print head 113 comprises a squeegee print head or a pressure-driven print head as disclosed, for example, in WO-A-98/16387. In a preferred embodiment the print head 113 is a pressure-driven print head; such a print head 113 advantageously allowing for the printing of inverted workpieces 103.

The carriage assembly 115 comprises a pair of guide rails 117, 117 which are mounted to the housing 109, a support block 119 which is slideably disposed to the guide rails 117, 117 and supports the print head 113, and a drive unit 120 which includes a motor-driven continuous drive belt 121 for driving the support block 119 and hence the print head 113 over the printing screen 111. In alternative embodiments the carriage assembly 115 could be driven by a worm drive, a pulley system or any other conventional drive mechanism.

The carriage assembly 115 further comprises at least one actuator 122 for biasing the print head 113 into pressure contact with the printing screen 111 during printing.

The print module 101 further comprises an alignment system 123 for aligning the print module 101 to the workpiece 103 as required. In a preferred embodiment the alignment system 123 includes a video camera for locating fiducials or other locating indicators on the workpiece 103. One suitable system is disclosed in WO-A-95/14575 and US-A-5752446.

In a preferred embodiment the print module 101 is detachable, preferably automatically, from the positioning assembly 105 such that different print modules 101, for example, with differently patterned and/or sized printing screens 111, can be interchanged as required. In one embodiment the print module 101 could be interchanged for each print run, potentially comprising a single workpiece 103, to allow for the printing of different patterns and/or differently-sized workpieces 103. In another embodiment the print module 101 could be interchanged to allow for the printing of a plurality of different patterns and/or pattern sizes on a single workpiece 103. It is a particular advantage that the print module 101 can be readily interchanged, allowing for the use of print modules 101 having different screen patterns and/or screen sizes.

In this embodiment the print module 101 has a significantly smaller lateral dimension than the workpiece 103. In this way, the print module 101 can be operated to print in a recess in the surface of the workpiece 103, which recess would not be accessible when using a printing screen 111 having the same lateral dimension as the workpiece 103, and also print a plurality of different patterns on the same workpiece 103. The present invention thus enables different combinations of circuit patterns to be printed easily and rapidly on a workpiece 103 without the need for dedicated printing screens 111 for each of the particular combinations of circuit patterns. Of course, in other embodiments the print module 101 could have a lateral dimension the same size or greater than the workpiece 103.

The positioning assembly 105 is configured to provide for movement of the print module 101 in the X. Y and Z axes, which movement allows for the positioning of the print module 101 on the surface of the workpiece 103.

The positioning assembly 105 includes an arm unit 126 which comprises an arm 127 which extends in a direction substantially parallel to the Y axis, a coupling 128 which is disposed at the distal end of the arm 127 and to which the print module 101 is mounted, a first arm drive member 129, in this embodiment a motor, for providing angular rotation θ of the print module 101 relative to the arm 127 about the Z axis, a second arm drive member 130, in this embodiment a motor, for driving the arm 127 and hence translating the print module 101 in the Y axis, and a third arm drive member 131, in this embodiment a motor, for providing angular rotation ξ of the arm 127 and hence the print module 101 about the Y axis.

In this embodiment the coupling 128 of the arm unit 126 of the positioning assembly 105 is attached to the print module 101 by a mechanical connection. In this embodiment the coupling 128 includes a clamp and the print module 101 includes a structural feature, for example, a protrusion or a handle, which is engaged by the clamp on the coupling 128. In another embodiment the print module 101 includes a clamp and the coupling 128 includes a structural feature, for example, a protrusion or a handle, which is engaged by the clamp on the print module 1.

In another embodiment the coupling 128 on the arm unit 126 of the positioning assembly 105 can be attached to the print module 101 by a magnetic connection. In one variant the coupling 128 could include an electromagnet which is magnetically clamped to the print module 101. In another variant the print module 101 could include an electromagnet which is magnetically clamped to the coupling 128.

The positioning assembly 105 further includes a beam unit 132 which comprises a beam 133 which extends in a direction substantially parallel to the X axis and to which the arm 127 of the arm unit 126 is movably disposed, a first beam drive member 134, in this embodiment a motor, for driving the beam 133 and hence translating the print module 101 in the X axis, and a second beam drive member 135 for providing angular rotation ϕ of the beam 133 and hence the print module 101 about the X axis.

The positioning assembly 105 further includes a pillar unit 136 which comprises a pillar 137 which extends in a direction substantially parallel to the Z axis and to which the beam 133 is movably disposed, a first pillar drive member 138, in this embodiment a motor, for driving the pillar 137 and hence translating the print module 101 in the Z axis, and a second pillar drive member 139 for providing angular rotation γ of the pillar 137 about the Z axis and hence rotate the print module 101 in an arc about the Z axis.

By providing for angular rotation θ of the print module 101 about the Z axis, that is, an axis perpendicular to the plane of the printing screen 111, a pattern in the printing screen 111 can be deposited with any orient on a planar surface. By further providing for angular rotation ϕ, ξ about the X and Y axes, the print module 101 can be translated and rotated to any position in space and allows for the printing onto non-planar surfaces.

In this embodiment the controller is a programmable computer. The controller can be programmed to position the print module 1 at the required position or sequentially at the required positions and control the operation of the print module 1.

In one mode of operation, the controller is programmed to operate the workpiece transport device to inwardly transport a workpiece 103 to the printing zone, and then operate the positioning assembly 105 first to pick up a selected print module 101 from a store in an acquiring step, position the selected print module 101 in a predetermined position above the workpiece 103, and then, in a printing step, move the selected print module 101 into abutment with the workpiece 103 and drive the print head 113 across the printing screen 111 to deposit a pattern of deposits of printing material onto the workpiece 103. The printing step can then be repeated on further workpieces 103 until a given print run is completed. Where a plurality of workpieces 103 are to be printed in a print run, then at the same time, while a workpiece 103 is being printed, a new workpiece 103 to be printed is transported to the printing zone and a printed workpiece 103 is transported from the printing zone. The print module 101 is then returned to the store by the positioning assembly 105 under the control of the controller. In a subsequent print run, a different print module 101. for example, with a differently-patterned printing screen 111, could be picked up by the positioning assembly 105, whereupon the above steps would then be repeated to provide a print run of workpieces 103 having the different printed pattern thereon. The printing steps may be interrupted with a cleansing step in which the print module 101 is moved to a cleansing station and the printing screen 111 wiped clean, as required.

In another mode of operation, where a customised pattern of deposits is to be printed using a plurality of print modules 101. the controller is programmed to operate the workpiece transport device to inwardly transport a workpiece 103 to the printing zone, and then operate the positioning assembly 105 to in turn select and operate a plurality of different print modules 101 to achieve the required pattern of deposits of printing material, with the operation of each of the print modules 101 being as described hereinabove.

In a preferred embodiment the controller is programmable "on-the-fly" so that new instructions can be inputted, for example, for a print run requiring yet another print module 10.1, without having to interrupt the current print run.

Finally, it will be understood that the present invention has been described in its preferred embodiments and can be modified in many different ways without departing from the scope of the invention as defined by the appended claims.

In other embodiments various other mechanisms can be utilised to position the print module 1. 101. The only necessary movement of the print module 1. 101 is in the X, Y and Z directions, with angular rotation θ of the print module 1, 101 about the Z axis, that is, an axis perpendicular to the printing screen 11, 111, being preferable.

In another modification, whilst the above-described embodiments provide a printing module 1, 101 of unitary construction which is positioned by a robotic arm 5 or positioning assembly 105, the apparatus could include first and second robotic arms 5 or positioning assemblies 105 for separately positioning and operating the printing screen 11, 111 and the print head 13, 113.

It will also be understood that the screen printing apparatus of the present invention need not be used alone as a dedicated screen printer, but could be incorporated in other equipment. In one embodiment the screen printing apparatus could form part of another machine with a different function, for example, a component placing mechanism.

## Claims

1. A method of printing a predeterminable pattern of deposits of printing material onto a workpiece (3; 103), the method comprising the steps of:
selecting a first print module (1; 101);
positioning the first-selected print module (1; 101) in a predeterminable position above the workpiece (3; 103) in a printing zone;
printing deposits of printing material onto a workpiece (3; 103) using the first-selected print module (1; 101);
returning the first-selected print module (1; 101);
selecting a second print module (1; 101);
positioning the second-selected print module (1; 101) in a predeterminable position above the workpiece (3; 103) in the printing zone; and
printing deposits of printing material onto the workpiece (3; 103) using the second-selected print module (1; 101).

2. The method of claim 1, further comprising the steps of:
selecting a further print module (1; 101);
positioning the further-selected print module (1; 101) in a predeterminable position above the workpiece (3; 103) in the printing zone; and
printing deposits of printing material onto the workpiece (3; 103) using the further-selected print module (1; 101).

3. The method of claim 1 or 2, wherein the print module (1; 101) comprises, as a detachable unitary assembly, a printing screen (11; 111), and a print head (13; 113) movable across the printing screen (11; 111).

4. The method of claim 3, wherein the print module (1; 101) further comprises a drive mechanism (20; 120) for moving the print head (13; 113) with respect to the printing screen (11; 111).

5. The method of claim 4, wherein the drive mechanism (20; 120) comprises a continuous belt (21; 121) connected to the print head (13; 113) and a motor for driving the belt (21; 121) to move the print head (13; 113) across the printing screen (11; 111), and/or the drive mechanism (21; 120) comprises at least one actuator (22; 122) which is operable to drive the print head (13; 113) into pressure contact with the printing screen (11; 111).

6. The method of any of claims 1 to 5, wherein the steps of selecting a print module (1; 101), positioning the selected print module (1; 101) and printing using the selected print module (1; 101) comprise the steps of:
picking up a print module (1; 101);
moving the selected print module (1; 101) to the predeterminable position above the workpiece (3; 103) in the printing zone; and
moving the selected print module (1; 101) into abutment with the workpiece (3; 103); and
operating the selected print module (1; 101) to print deposits of printing material onto the workpiece (3; 103).

7. The method of claim 6, wherein the step of returning a selected print module (1; 101) comprises the step of:
moving the selected print module (1; 101) out of abutment with the workpiece (3; 103).

8. The method of claim 7, wherein the step of returning a selected print module (1; 101) further comprises the steps of:
moving the selected print module (1; 101) to a cleaning station; and
cleaning the print head (13; 113) of the selected print module (1; 101).

9. A screen printing apparatus for printing a predeterminable pattern of deposits of printing material onto a workpiece (3; 103), the screen printing apparatus comprising:
a plurality of print modules (1; 101), each comprising, as a unitary assembly, a printing screen (11; 111), a print head (13; 113) movable across the printing screen (11; 111), and a drive mechanism (20; 120) for moving the print head (13; 113) with respect to the printing screen (11; 111); and
a positioning unit for positioning, in succession, a first-selected print module in a predeterminable position above the workpiece (3; 103) in a printing zone and a second-selected print module (1; 101) in a predeterminable position above the workpiece (3; 103) in the printing zone.

10. The apparatus of claim 9, wherein the print modules (1; 101) are detachably mounted to the positioning unit.

11. The apparatus of claim 9 or 10, or the method of any of claims 1 to 8, wherein the print modules (1; 101) each have a different function, and/or the printing screens (11; 111) of the print modules (1; 101) are different.

12. The apparatus of any of claims 9 to 11, wherein the positioning unit is configured to move the selected print module (1; 101) in a plane along orthogonal X and Y axes, and vertically towards and away from the workpiece (3; 103) along a Z axis orthogonal to the X and Y axes.

13. The apparatus of claim 12, wherein the positioning unit is configured to rotate the selected print module (1; 101) about a point in the plane defined by the X and Y axes, and/or the positioning unit is configured to rotate the selected print module (1; 101) about the Z axis, and/or the positioning unit is configured to rotate the selected print module (1; 101) about the X axis, and/or the positioning unit is configured to rotate the selected print module (1; 101) about the Y axis.

14. The apparatus of any of claims 9 to 13, wherein the positioning unit is (i) a robotic positioning arm (5), or (ii) a positioning assembly (105) comprising an arm (127) extending parallel to the Y axis and to which the selected print module (101) is mounted, a beam (133) extending parallel to the X axis, a pillar (137) extending parallel to the Z axis, and drive members (130, 134, 138) for providing relative movement of the arm (127), the beam (133) and the pillar (137).

15. The apparatus of claim 14, wherein the positioning assembly (105) further comprises a drive member (129) for rotating the selected print module (101) about the Z axis, and/or drive members (131, 135) for rotating the arm (127) about the Y axis and the beam (133) about the X axis, and/or a drive member (139) for rotating the pillar (137) about the Z axis.

16. The apparatus of any of claims 9 to 15, or the method of any of claims 1 to 8, wherein the printing screen (11; 111) has a smaller lateral dimension than that of the workpiece (3; 103).

## Patentansprüche

1. Verfahren zum Drucken eines bestimmten Musters von Ablagerungen eines Druckmaterials auf einem Werkstück (3, 103), wobei das Verfahren die Schritte umfasst:
Auswählen eines ersten Druckmoduls (1, 101);
Positionieren des erst-gewählten Druck-Moduls (1, 101) in einer bestimmten Position oberhalb des Werkstücks (3, 103) in einem Druckbereich;
Drucken von Ablagerungen von Druckmaterial auf einem Werkstück (3, 103) unter Verwendung des erst-gewählten Druckmoduls (1, 101);
Zurückführen des erst-gewählten Druckmoduls (1, 101);
Auswählen eines zweiten Druckmoduls (1, 101);
Positionieren des zweit-gewählten Druck-Moduls (1, 101) in einer bestimmten Position oberhalb des Werkstücks (3, 103) in einem Druckbereich; und
Drucken von Ablagerungen des Druckmaterials auf dem Werkstück (3, 103) unter Verwendung des zweit-gewählten Druckmoduls (1, 101).

2. Verfahren nach Anspruch 1, welches weiter die Schritte umfasst:
Auswählen eines weiteren Druckmoduls (1, 101);
Positionieren des weiter-gewählten Druck-Moduls (1, 101) in einer bestimmten Position oberhalb des Werkstücks (3, 103) in einem Druckbereich; und
Drucken von Ablagerungen von Druckmaterial auf dem Werkstück (3, 103) unter Verwendung des weiter-gewählten Druckmoduls (1, 101).

3. Verfahren nach Anspruch 1 oder 2, wobei das Druckmodul (1, 101) als einen abnehmbaren Einheits-Aufbau umfasst, ein Drucksieb (11, 111) und einen Druckkopf (13, 113), der über das Drucksieb (11, 111) bewegbar ist.

4. Verfahren nach Anspruch 3, wobei das Druckmodul (1, 101) weiter umfasst, einen Antriebsmechanismus (20, 120) zur Bewegung des Druckkopfs (13, 113) in Bezug auf das Drucksieb (11, 111).

5. Verfahren nach Anspruch 1, wobei der Antriebsmechanismus (20, 120) ein Endlosband (21, 121) umfasst, das mit dem Druckkopf (13, 113) verbunden ist, und einen Motor zum Antreiben des Bandes (21, 121) um den Druckkopf (13, 113) über das Drucksieb (11, 111) zu bewegen und/oder worin der Antriebsmechanismus (21, 121) umfasst, mindestens ein Bestätigungsmittel (22, 122), das betätigbar ist, um den Druckkopf (13, 113) in Druckkontakt mit dem Drucksieb (11, 111) zu bringen.

6. Verfahren nach einem der Ansprüche 1 bis 5, wobei die Schritte des Auswählens eines Druckmoduls (1, 101), des Positionierens des gewählten Druckmoduls (1, 101) und des Druckens unter Verwendung des gewählten Druckmoduls (1, 101) die Schritte umfasst:
Aufnehmen eines Druckmoduls (1, 101);
Bewegen des gewählten Druckmoduls (1, 101) in eine bestimmte Position oberhalb des Werkstücks (3, 103) in dem Druckbereich; und
Bewegen des gewählten Druckmoduls (1, 101) in Auflage auf das Werkstück (3, 103); und
Betreiben des gewählten Druckmoduls (1, 101), um Ablagerungen an Druckmaterial auf das Werkstück zu drucken.

7. Verfahren nach Anspruch 6, wobei der Schritt des Rückführens des gewählten Druckmoduls (1, 101) den Schritt umfasst:
Bewegen des gewählten Druckmoduls (1, 101) aus der Auflage auf dem Werkstück (3, 103) heraus.

8. Verfahren nach Anspruch 1, wobei der Schritt des Rückführend des gewählten Druckmoduls (1, 101) weiter die Schritte umfasst:
Bewegen des gewählten Druckmoduls (1, 101) in eine Reinigungsstation; und
Reinigen des Druckkopfs (13, 113) des gewählten Druckmoduls (1, 101).

9. Siebdruck-Vorrichtung zum Drucken eines bestimmten Musters an Ablagerungen eines Druckmaterials auf ein Werkstück (3, 103), worin die Siebdruck-Vorrichtung umfasst,:
mehrere Druckmodule (1, 101), die jeweils als Einheits-Aufbau umfassen, ein Drucksieb (11, 111), einen Druckkopf (13, 113), der über das Drucksieb (11, 111) bewegbar ist, und einen Antriebsmechanismus (20, 120) zur Bewegung des Druckkopfs (13, 113) in Bezug auf das Drucksieb (11, 111); und
eine Positionierungseinheit zur Positionierung, nacheinander, eines erst-gewählten Druckmoduls in einer bestimmten Position über dem Werkstück (3, 103) in einem Druckbereich, und eines zweit-gewählten Druckmoduls in einer bestimmten Position über dem Werkstück (3, 103) in dem Druckbereich.

10. Vorrichtung nach Anspruch 9, worin die Druckmodule (1, 101) auf der Positionierungseinheit abnehmbar befestigt sind.

11. Vorrichtung nach Anspruch 9 oder 10, oder Verfahren nach einem der Ansprüche 1 bis 8, worin die Druckmodule (1, 101) jeweils unterschiedliche Funktionen besitzen und/oder worin die Drucksiebe (11, 111) der Druckmodule (1, 101) verschieden sind.

12. Vorrichtung nach einem der Ansprüche 9 bis 11, worin die Positionierungseinheit ausgestaltet ist, das gewählte Druckmodul (1, 101) in einer Ebene entlang orthogonaler X- und Y-Achsen zu bewegen und vertikal auf das Werkstück (3, 103) zu und weg davon entlang einer Z-Achse, die orthogonal zu der X- und Y-Achse steht.

13. Vorrichtung nach Anspruch 12, worin die Positionierungseinheit ausgestaltet ist, das gewählte Druckmodul (1, 101) um einen Punkt in der durch die X- und Y-Achse definierten Ebene zu rotieren und/oder worin die Positionierungseinheit ausgestaltet ist, das gewählte Druckmodul (1, 101) um die Z-Achse zu rotieren und/oder worin die Positionierungseinheit ausgestaltet ist, das gewählte Druckmodul (1, 101) um die X-Achse zu bewegen, und/oder worin Positionierungseinheit ausgestaltet ist, das gewählte Druckmodul (1, 101) um die Y-Aclase zu bewegen.

14. Vorrichtung nach einem der Ansprüche 9 bis 13, worin die Positionierungseinheit (i) ein Roboter-Positionierungsarm (5) ist, oder (ii) ein Positionierungs-Aufbau (105), der umfasst, einen Arm, der sich parallel zur Y-Achse erstreckt und an den das gewählte Druckmodul (1, 101) befestigt ist, einen Träger (133), der sich parallel zur X-Achse erstreckt, einen Pfeiler (137), der sich parallel zur Z-Achse erstreckt, und Antriebselemente (130, 134, 138), um eine relative Bewegung des Arms (127), des Trägers (133) und des Pfeilers (137) zu liefern.

15. Vorrichtung nach Anspruch 14, worin der Positionierungs-Aufbau (105) weiter umfasst, ein Antriebselement (129) zum Rotieren des gewählten Druckmoduls (1, 101) um die Z-Achse und/oder Antriebselemente (131, 135) zum Rotieren des Arms (127) um die Y-Achse und des Trägers (133) um die X-Achse, und/oder ein Antriebselement (139) zum Rotieren des Pfeilers (137) um die Z-Achse.

16. Vorrichtung nach einem der Ansprüche 9 bis 15 oder Verfahren nach einem der Ansprüche 1 bis 8, worin das Drucksieb (11, 111) kleinere laterale Abmessungen aufweist, als das Werkstück (3, 103).

## Revendications

1. Procédé d'impression d'un motif prédéterminé de dépôts de matériau d'impression sur une pièce de travail (3 ; 103), le procédé comprenant les étapes de :
sélection d'un premier module d'impression (1 ; 101) ;
positionnement du premier module d'impression sélectionné (1 ; 101) dans une position pouvant être prédéterminée au-dessus de la pièce de travail (3 ; 103) dans une zone d'impression ;
impression de dépôts de matériau d'impression sur une pièce de travail (3 ; 103) en utilisant le premier module d'impression sélectionné (1 ; 101) ;
retour du premier module d'impression sélectionné (1 ; 101) ;
sélection d'un second module d'impression (1 ; 101) ;
positionnement du second module d'impression sélectionné (1 ; 101) dans une position pouvant être prédéterminée au-dessus de la pièce de travail (3 ; 103) dans la zone d'impression ; et
impression de dépôts de matériau d'impression sur la pièce de travail (3 ; 103) en utilisant le second module d'impression sélectionné (1 ; 101).

2. Procédé selon la revendication 1, comprenant en outre les étapes de :
sélection d'un autre module d'impression (1 ; 101) ;
positionnement de l'autre module d'impression sélectionné (1 ; 101) dans une position pouvant être prédéterminée au-dessus de la pièce de travail (3 ; 103) dans la zone d'impression ; et
impression de dépôts de matériau d'impression sur la pièce de travail (3 ; 103) en utilisant l'autre module d'impression sélectionné (1 ; 101).

3. Procédé selon la revendication 1 ou 2, dans lequel le module d'impression (1 ; 101) comprend, comme ensemble unitaire détachable, un pochoir (11 ; 111) et une tête d'impression (13 ; 113) mobile sur le pochoir (11 ; 111).

4. Procédé selon la revendication 3, dans lequel le module d'impression (1 ; 101) comprend en outre un mécanisme d'entraînement (20 ; 120) pour le déplacement de la tête d'impression (13 ; 113) par rapport au pochoir (11 ; 111).

5. Procédé selon la revendication 4, dans lequel le mécanisme d'entraînement (20 ; 120) comprend une sangle continue (21 ; 121) reliée à la tête d'impression (13 ; 113) et un moteur pour l'entraînement de la sangle (21 ; 121) afin de déplacer la tête d'impression (13 ; 113) sur le pochoir (11 ; 111) et/ou le mécanisme d'entraînement (21 ; 120) comprend au moins un actionneur (22 ; 122) qui est actionnable pour entraîner la tête d'impression (13 ; 113) en pression de contact avec le pochoir (11 ; 111).

6. Procédé selon l'une quelconque des revendications 1 à 5, dans lequel les étapes de sélection d'un module d'impression (1 ; 101), de positionnement du module d'impression sélectionné (1 ; 101) et d'impression en utilisant le module d'impression sélectionné (1 ; 101) comprennent les étapes de :
préhension d'un module d'impression (1 ; 101) ;
déplacement du module d'impression sélectionné (1 ; 101) dans la position pouvant être prédéterminée au-dessus de la pièce de travail (3 ; 103) dans la zone d'impression ; et
déplacement du module d'impression sélectionné (1 ; 101) en butée avec la pièce de travail (3 ; 103) ; et
actionnement du module d'impression sélectionné (1 ; 101) pour imprimer les dépôts de matériau d'impression sur la pièce de travail (3 ; 103).

7. Procédé selon la revendication 6, dans lequel l'étape de retour d'un module d'impression sélectionné (1 ; 101) comprend l'étape de :
déplacement du module d'impression sélectionné (1 ; 101) hors de butée avec la pièce de travail (3 ; 103).

8. Procédé selon la revendication 7, dans lequel l'étape de retour d'un module d'impression sélectionné (1 ; 101) comprend en outre les étapes de :
déplacement du module d'impression sélectionné (1 ; 101) à un poste de nettoyage ; et
nettoyage de la tête d'impression (13 ; 113) du module d'impression sélectionné (1 ; 101).

9. Appareil de sérigraphie pour l'impression d'un motif pouvant être prédéterminé de dépôts de matériau d'impression sur une pièce de travail (3 ; 103), l'appareil de sérigraphie comprenant :
une pluralité de modules d'impression (1 ; 101) comprenant chacun, comme ensemble unitaire, un pochoir (11 ; 111), une tête d'impression (13 ; 113) mobile sur le pochoir (11 ; 111) et un mécanisme d'entraînement (20 ; 120) pour le déplacement de la tête d'impression (13 ; 113) par rapport au pochoir (11 ; 111) ; et
une unité de positionnement pour le positionnement successivement d'un premier module d'impression sélectionné dans une position pouvant être prédéterminée au-dessus de la pièce de travail (3 ; 103) dans une zone d'impression et d'un second module d'impression sélectionné (1 ; 101) dans une position pouvant être prédéterminée au-dessus de la pièce de travail (3 ; 103) dans la zone d'impression.

10. Appareil selon la revendication 9, dans lequel les modules d'impression (1 ; 101) sont montés de manière détachable sur l'unité de positionnement.

11. Appareil selon la revendication 9 ou 10 ou procédé selon l'une quelconque des revendications 1 à 8, dans lequel les modules d'impression (1 ; 101) ont chacun une fonction différente et/ou les pochoirs (11 ; 111) des modules d'impression (1 ; 101) sont différents.

12. Appareil selon l'une quelconque des revendications 9 à 11, dans lequel l'unité de positionnement est configurée pour déplacer le module d'impression sélectionné (1 ; 101) dans un plan le long d'axes X et Y orthogonaux et verticalement vers et loin de la pièce de travail (3 ; 103) le long d'un axe Z orthogonal aux axes X et Y.

13. Appareil selon la revendication 12, dans lequel l'unité de positionnement est configurée pour tourner le module d'impression sélectionné (1 ; 101) autour d'un point dans le plan défini par les axes X et Y, et/ou l'unité de positionnement est configurée pour tourner le module d'impression sélectionné (1 ; 101) autour de l'axe Z et/ou l'unité de positionnement est configurée pour tourner le module d'impression sélectionné (1 ; 101) autour de l'axe X et/ou l'unité de positionnement est configurée pour tourner le module d'impression sélectionné (1 ; 101) autour de l'axe Y.

14. Appareil selon l'une quelconque des revendications 9 à 13, dans lequel l'unité de positionnement est (i) un bras de positionnement robotique (5) ou (ii) un ensemble de positionnement (105) comprenant un bras (127) s'étendant parallèlement à l'axe Y et sur lequel le module d'impression sélectionné (101) est monté, une poutre (133) s'étendant parallèlement à l'axe X, un pilier (137) s'étendant parallèlement à l'axe Z, et des éléments d'entraînement (130, 134, 138) pour fournir un mouvement relatif du bras (127), de la poutre (133) et du pilier (137).

15. Appareil selon la revendication 14, dans lequel l'ensemble de positionnement (105) comprend en outre un élément d'entraînement (129) pour la rotation du module d'impression sélectionné (101) autour de l'axe Z, et/ou des éléments d'entraînement (131, 135) pour la rotation du bras (127) autour de l'axe Y et de la poutre (133) autour de l'axe X et/ou un élément d'entraînement (139) pour la rotation du pilier (137) autour de l'axe Z.

16. Appareil selon l'une quelconque des revendications 9 à 15 ou procédé selon l'une quelconque des revendications 1 à 8, dans lequel le pochoir (11 ; 111) a une dimension latérale inférieure à celle de la pièce de travail (3 ; 103).
